# EUROPEAN PATENT SPECIFICATION

(11) **EP 4 668 468 B1**
(45) Date of publication and mention of the grant of the patent: **26.08.2026**
(21) Application number: 25184204.3
(22) Date of filing: 20.06.2025
(51) Int. Cl.: H01M 50/562, H01M 50/571, H01M 50/178, H01M 50/534

(54) **LEAD TAB WITH IMPROVED ADHESION**
ANSCHLUSSFAHNE MIT VERBESSERTER HAFTUNG
LANGUETTE DE CONNEXION À ADHÉRENCE AMÉLIORÉE

(30) Priority: 20.06.2024 KR 20240080232
(43) Date of publication of application: 24.12.2025
(73) Proprietor: Flexion Co., Ltd, Jeongeup-si, Jeollabuk-do 56137 (KR)
(72) Inventor: YU, Jinha, 56137 Jeollabuk-do (KR); NOH, Hyeongwan, 56137 Jeollabuk-do (KR); CHOI, Sunghoon, 56137 Jeollabuk-do (KR)
(74) Representative: Ter Meer Steinmeister & Partner

(56) References cited:
- JP-A- H05 242 909
- KR-A- 20230 046 996
- KR-B1- 102 655 799
- US-A1- 2024 186 526

## Description

This application claims the benefit of priority of the Korean Patent Application No. 10-2024-0080232 filed on June 20, 2024.

### BACKGROUND

### Field of the Invention

The present invention relates to a lead tab with improved adhesion.

### Discussion of the Related Art

The secondary battery industry is in the spotlight as a core component of IT devices along with semiconductors and displays. Recently, its use is increasing for electric bicycles, hybrid vehicles (HEVs), electric vehicles (EVs), plug-in hybrid vehicles (PHEVs), and energy storage systems (ESS) that use large-capacity batteries.

Typical secondary battery has a lead tab provided to extract electricity to the outside. In a secondary battery, one end of the lead tab is connected to the battery element and is pressed against the opposing film, and the other end protrudes to the outside of the film.

In secondary batteries, surface treatment of the lead tab is necessary to facilitate adhesion between the lead tab and the insulating film and to prevent defects such as corrosion or peeling due to stimulation inside and outside the battery in an actual use environment after adhesion.

Meanwhile, the material used in the conventional surface treatment technology was hexavalent chromium. However, surface treatment methods using hexavalent chromium are currently being regulated or used in a limited manner worldwide due to human hazards and environmental issues.

To solve these problems, research is continuously being conducted on lead tabs with improved adhesion. See, for example, KR 2023 0046996 A, and KR 102 655 799 B1, both of which disclose a copper lead tab coated with nickel.

### SUMMARY

The present invention relates to a lead tab with improved adhesion that can prevent problems caused by the limitations and disadvantages of the above-mentioned related technologies.

One embodiment of the present invention provides a lead tab including: a metal substrate; a nickel-plated layer laminated on both sides of the metal substrate; and a metal layer on the nickel-plated layer, wherein the metal layer contains 70 to 99.9 wt% of chromium and wherein the lead tab has a gloss of 60 to 100 (Gs 60°), and has a water contact angle of 60 to 80°.

### BRIEF DESCRTPTION OF THE DRAWINGS

The above and other objects, features and other advantages of the present disclosure will be more clearly understood from the following detailed description taken in conjunction with the accompanying drawings, in which:
FIG. 1 is a perspective view of a secondary battery according to one embodiment of the present invention.
FIG. 2 is a cross-sectional view of a lead tab according to one embodiment of the present invention.
FIG 3 is a cross-sectional view taken along line I-I' of FIG 1.

### DETAILED DESCRIPTION OF THE DISCLOSURE

Hereinafter, embodiments of the present disclosure will be described in detail with reference to the accompanying drawings. However, the embodiments described below are presented only for illustrative purposes to facilitate a clear understanding of the present disclosure and do not limit the scope of the present disclosure.

Shapes, sizes, ratios, angles, numbers, and the like disclosed in the drawings for describing the embodiments of the present disclosure are illustrative, and thus the present disclosure is not limited to the details illustrated in the drawings. Throughout the present specification, the same components may be referred to by the same reference numerals. In describing the present disclosure, detailed descriptions of related known technologies will be omitted when it is determined that they may unnecessarily obscure the gist of the present disclosure.

When terms "including," "having," "consisting of," and the like described in the present specification are used, other parts may be added unless the term "only" is used herein. When a component is expressed in the singular form, the plural form is included unless otherwise specified. In addition, in interpreting a component, it is interpreted as including an error range even when not explicitly stated.

In describing a positional relationship, for example, when a positional relationship of two parts is described as being "on," "above," "below, "next to," or the like, unless "immediately" or "directly" is used, one or more other parts may be located between the two parts.

Spatially relative terms, such as "below," "beneath," "lower," "above," "upper" and the like, may be used herein for ease of description to describe one element or component's relationship to another element(s) or component(s) as illustrated in the drawings. It will be understood that the spatially relative terms are intended to include different orientations of the element in use or operation in addition to the orientation illustrated in the drawings. For example, when an element in the drawings is turned over, an element described as being "above" or "upper" relative to another element will then be "below" or "lower" relative to the other element. Thus, the exemplary term "below" may include both above and below orientations. Likewise, the exemplary terms "above" or "upper" may include both above and below orientations.

In describing a temporal relationship, for example, when a temporal relationship is described as being "after," "subsequent," "next to," "prior to," or the like, unless "immediately" or "directly" is used, cases that are not continuous may also be included.

In order to describe various components, terms such as "first," "second," and the like are used, but these components are not limited by these terms. These terms are only used to distinguish one component from another component. Accordingly, a first component described below may be a second component within the technical idea of the present disclosure.

The term "at least one" should be understood to include all possible combinations from one or more related items. For example, the meaning of "at least one of first, second, and third items" may mean all combinations of two or more items of the first, second and third items as well as each of the first, second and third items.

The features of various embodiments of the present disclosure may be partially or wholly coupled to or combined with each other, and may be various technically linked or operated, and each of the embodiments may be implemented independently of each other or may be implemented together in a related relationship.

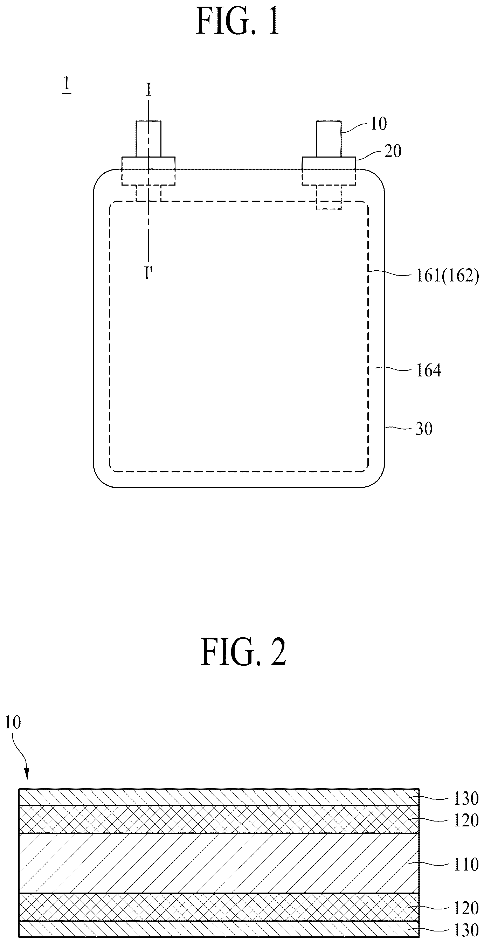

FIG. 1 is a perspective view of a secondary battery (1) according to one embodiment of the present invention.

FIG. 2 is a cross-sectional view of a lead tab (10) according to one embodiment of the present invention.

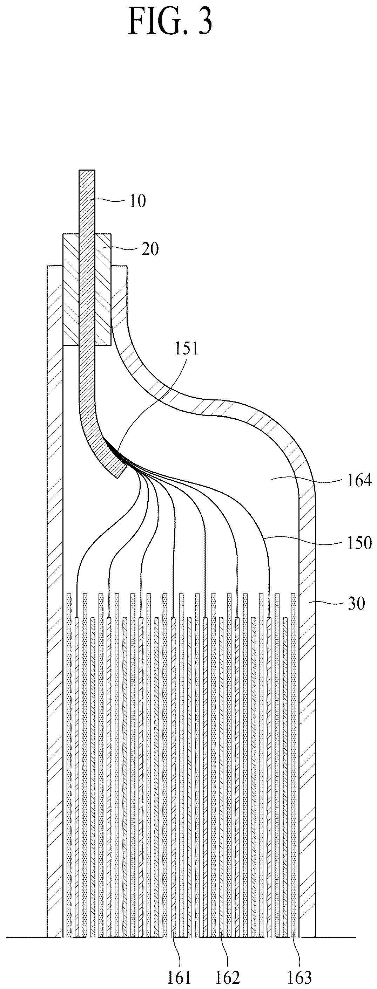

FIG 3 is a cross-sectional view taken along line I-I' of FIG 1.

There is no particular limitation on the type of secondary battery (1) according to one embodiment of the present invention, but it may preferably be a lithium secondary battery.

Referring to FIGS. 1 and 3, a secondary battery (1) according to one embodiment of the present invention is configured such that a film-shaped negative electrode (161) and a film-shaped positive electrode (162) are disposed in a state of being overlapped with each other via a separator (163), and an electrolyte (164) is disposed between the negative electrode (161) and the positive electrode (162) so as to enable charging and discharging by the transfer of lithium ions. The secondary battery (1) including the negative electrode (161), the positive electrode (162), and the electrolyte (164) is covered in a liquid-tight state by an outer case (30). Specifically, the negative electrode (161), the positive electrode (162), and the electrolyte (164) are sealed inside the outer case (30) to protect them from the outside. In addition, the negative electrode (161) is formed as a structure in which a secondary battery copper foil is used as an negative electrode collector and a negative electrode active material slurry is coated thereon. Likewise, the positive electrode (162) is formed with a structure in which a positive electrode active material slurry is coated on a positive electrode current collector such as aluminum.

In addition, although not shown in the drawing, the lead tab (10) may be composed of a negative lead tab and a positive lead tab. More specifically, the lead tab (10) disposed on the left side of Fig. 1 may be a negative lead tab, and the lead tab (10) disposed on the right side may be a positive lead tab.

Referring to Fig. 1, a sealing tape (20) is disposed on one side of the outer case (30) of the secondary battery (1). The sealing tape (20) is intended to further improve the adhesiveness between the lead tab (10) and the outer case (30). The sealing tape (20) is disposed on the lead tab (10), and a portion of the sealing tape (20) is in close contact with the inner surface of the outer case (30) to seal the outer case (30). The sealing tape (20) has a function of preventing leakage of a liquid such as an electrolyte (164) sealed inside the outer case (30). In addition, the sealing tape (20) is disposed between the lead tab (10) and the outer case (30) to secure insulation between the lead tab (10) and the outer case (30). A polypropylene film is used as the sealing tape (20). However, one embodiment of the present invention is not limited thereto, and may be formed of a polymer-based composite.

Referring to Fig. 1, one end of the lead tab (10) is connected to one of the positive electrode (161) and the negative electrode (162), and the other end of the lead tab (10) is exposed to the outside of the outer body (30).

As illustrated in FIG. 2, the lead tab (10) of the present invention includes a metal substrate (110) including copper (Cu), a nickel-plated layer (120) on the metal substrate (110), and a metal layer (130) on the nickel-plated layer (120). The metal substrate (110), the nickel-plated layer (120), and the metal layer (130) are described in detail below.

Referring to FIG. 3, a plurality of electrode tabs (150) protruding from a cathode (161) are integrally combined to form a pre-welding portion (151), and a lead tab (10) is electrically connected to the upper portion of the pre-welding portion (151) by welding.

For example, in the case of ultrasonic welding as a welding method, when ultrasonic vibration is applied, frictional heat causes plastic deformation, allowing the lead tab (10) to penetrate and closely adhere to the pre-welding portion (151), which is formed by integrally bonding the electrode tabs (150).

The material of the metal substrate (110) is not particularly limited. According to one embodiment of the present invention, the metal substrate (110) may be rolled copper foil.

According to one embodiment of the present invention, the metal substrate (110) may have a thickness of 100 to 1,000 µm. Preferably, it may have a thickness of 100 to 500 µm.

A nickel-plated layer (120) is disposed on a metal substrate (110).

According to one embodiment of the present invention, since the nickel-plated layer (120) includes nickel (Ni), the lead tab (10) according to the embodiment of the present invention has an anti-oxidation effect and can have an effect of preventing corrosion by hydrofluoric acid generated by the reaction between the electrolyte and moisture.

According to one embodiment of the present invention, the nickel-plated layer (120) may have a thickness of 0.5 to 10.0 µm.

On the other hand, when the nickel-plated layer (120) has a thickness of less than 0.5 µm, the nickel-plated layer (120) may be unevenly deposited. As a result, the metal layer (130) disposed on the nickel-plated layer (120) may also be unevenly deposited, causing the lead tab (10) including them to have non-uniform corrosion resistance.

In addition, when the nickel-plated layer (120) has a thickness exceeding 10.0 µm, the internal stress within the nickel-plated layer (120) increases, causing a problem of cracks forming. Based on this, the nickel-plated layer (120) according to the embodiment of the present invention needs to have a thickness of 0.5 to 10.0 µm.

As such, the corrosion resistance of the lead tab (10) can be significantly improved through the nickel-plated layer (120) having excellent corrosion resistance. At the same time, the adhesion between the metal substrate (110) and the metal layer (130) can be enhanced, thereby further improving the overall corrosion resistance and sealing performance.

According to one embodiment of the present invention, the lead tab (10) further includes a metal layer (130) on the nickel-plated layer (120).

The metal layer (130) contains 70.0 to 99.9 wt%(weight/weight) of chromium (Cr).

Specifically, the metal layer (130) can be formed by a dry vacuum process. For example, the metal layer (130) can be formed by any one of a sputtering process, an evaporation process, an ion plating process, and a CVD process as examples of the dry vacuum process. Preferably, the metal layer (130) can be formed by a sputtering process.

When a metal layer (130) is formed on a nickel-plated layer (120) by a dry vacuum process, some nickel (Ni) may be included within the metal layer (130). Even in this case, the metal layer (130) may include 70.0 wt% or more of chromium (Cr).

In general, the lead tab further includes a protective layer containing a chromium compound to improve corrosion resistance. At this time, the protective layer is formed through chromate treatment. However, the protective layer formed by the chromate treatment may have a very high oxygen fraction in the protective layer. At this time, the oxygen fraction means the ratio of oxygen to the total number of atoms in the protective layer. A protective layer with a very high oxygen fraction may cause the metal layer in contact with the protective layer to be excessively oxidized, thereby reducing the adhesion between the lead tab and the insulating film.

In addition, in the case of a protective layer formed by chromate treatment, some trivalent chromium (Cr³⁺) or hexavalent chromium (Cr⁶⁺) may exist within the protective layer. At this time, the hexavalent chromium (Cr⁶⁺) existing within the protective layer may have a strong oxidizing power. As a result, the metal layer in contact with the protective layer may be excessively oxidized, which may reduce the adhesion between the lead tab and the insulating film.

Therefore, according to the present invention, in order to increase the adhesion between the lead tab (10) and the sealing tape (20), the metal layer (130) needs to contain 70 to 99.9 wt% of chromium (Cr).

According to the present invention, when the metal layer (130) is deposited by a sputtering process and contains 70 to 99.9 wt% of chromium (Cr), the oxygen fraction in the metal layer (130) is sufficiently reduced to achieve the purpose, thereby increasing the adhesion between the lead tab (10) and the sealing tape (20). As a result, defects such as corrosion or peeling due to stimulation inside and outside the battery may not occur in an actual use environment.

In addition, according to one embodiment of the present invention, when the metal layer (130) is deposited by a sputtering process and contains 70 to 99.9 wt% of chromium (Cr), hexavalent chromium (Cr⁶⁺) in the metal layer (130) can reduce the impact of harmful substances on human health and the environment, thereby suppressing the occurrence of harmful substances.

The lead tab (10) according to the present invention has a gloss of 60 to 100 (Gs 60°). The gloss (Gs 60°) according to one embodiment of the present invention is measured using a Gloss Meter (VG8000 product of Nippon Denshoku Co., Ltd.) at a light source irradiation angle of 60°. A method for measuring the gloss (Gs 60°) according to one embodiment of the present invention is described in detail below.

According to the present invention, when the lead tab (10) has a gloss of 60 to 100 (Gs 60°), the bonding strength between the metal layer (130) of the lead tab (10) and the sealing tape (20) is improved, so that defects such as corrosion or peeling due to stimulation inside and outside the battery may not occur in an actual use environment.

On the other hand, when the lead tab (10) has a gloss of less than 60 (Gs 60°), the surface of the metal layer (130) of the lead tab (10) becomes very rough, so that the bonding strength between the metal layer (130) of the lead tab (10) and the sealing tape (20) is reduced, and thus defects such as corrosion or peeling may occur due to stimulation inside and outside the battery in an actual use environment.

In addition, when the lead tab (10) has a gloss exceeding 100 (Gs 60°), the surface of the metal layer (130) of the lead tab (10) becomes very smooth, and thus the adhesion between the metal layer (130) of the lead tab (10) and the sealing tape (20) is likely to be uneven. As a result, defects such as corrosion or peeling may occur due to stimulation inside and outside the battery in an actual use environment.

According to the present invention, the lead tab (10) has a water contact angle of 60 to 80°. The water contact angle according to one embodiment of the present invention is measured using a contact angle measuring device (Phoenix-MT product of SIO Corporation). A method for measuring the water contact angle according to one embodiment of the present invention is described in detail below.

According to the present invention, when the lead tab (10) has a water contact angle of 60 to 80°, the bonding strength between the metal layer (130) of the lead tab (10) and the sealing tape (20) is improved, so that defects such as corrosion or peeling due to stimulation inside and outside the battery may not occur in an actual use environment.

On the other hand, if the lead tab (10) has a water contact angle of less than 60°, a large amount of polarity is formed on the surface of the lead tab (10), which may cause moisture adsorption and surface oxidation during storage or transportation. As a result, the bonding strength between the metal layer (130) of the lead tab (10) and the sealing tape (20) is reduced, and defects such as corrosion or peeling may occur due to stimulation inside and outside the battery in an actual use environment.

In addition, when the lead tab (10) has a water contact angle exceeding 80°, the metal layer (130) of the lead tab (10) and the sealing tape (20) are not properly adhered to each other, and a problem occurs in which the adhesion is poor. As a result, defects such as corrosion or peeling may occur due to stimulation inside and outside the battery in an actual use environment.

Preferably, it can have a water contact angle of 70 to 80°.

According to one embodiment of the present invention, the lead tab (10) can have an arithmetic mean roughness (Ra) of 0.06 to 0.15 *µ*m, a maximum height roughness (Ry) of 0.4 to 0.8 *µ*m, and a 10-point average roughness (Rz) of 0.3 to 0.6 *µ*m. The arithmetic mean roughness (Ra), the maximum height roughness (Ry), and the 10-point average roughness (Rz) according to one embodiment of the present invention are each measured using a Profiler (Surfcorder ET3000 product of KOSKA Lab). A method for measuring the arithmetic mean roughness (Ra), the maximum height roughness (Ry), and the 10-point average roughness (Rz) according to one embodiment of the present invention is described in detail below.

The definitions of arithmetic mean roughness (Ra), maximum height roughness (Ry), and 10-point average roughness (Rz) are as follows.

Arithmetic mean roughness (Ra): Arithmetic mean of the upper/lower absolute values based on the central height value of the entire measurement section

Maximum height roughness (Ry): The distance between the highest peak and the deepest valley among the five cut-off intervals.

10-point average roughness (Rz): The average of the heights of the five highest peaks and the depths of the five deepest valleys within a single cut-off length of the surface profile.

According to one embodiment of the present invention, when the lead tab (10) has an arithmetic mean roughness (Ra) of 0.06 to 0.15 *µ*m, a maximum height roughness (Ry) of 0.4 to 0.8 *µ*m, and a 10-point average roughness (Rz) of 0.3 to 0.6 *µ*m, the bonding strength between the metal layer (130) of the lead tab (10) and the sealing tape (20) is improved, so that defects such as corrosion or peeling due to stimulation inside and outside the battery may not occur in an actual use environment.

On the other hand, when the lead tab (10) has an arithmetic mean roughness (Ra) of less than 0.06 *µ*m, a maximum height roughness (Ry) of less than 0.4 *µ*m, or a 10-point average roughness (Rz) of less than 0.3 *µ*m, the area where the metal layer (130) of the lead tab (10) adheres to the sealing tape (20) is too small. The bonding strength between the metal layer (130) of the lead tab (10) and the sealing tape (20) is reduced, and thus defects such as corrosion or peeling may occur due to stimulation inside and outside the battery in an actual use environment.

In addition, when the lead tab (10) has an arithmetic mean roughness (Ra) exceeding 0.15 *µ*m, a maximum height roughness (Ry) exceeding 0.8 *µ*m, or a 10-point average roughness (Rz) exceeding 0.6 *µ*m, the surface of the metal layer (130) of the lead tab (10) becomes very rough, so that the bonding strength between the metal layer (130) of the lead tab (10) and the sealing tape (20) deteriorates, and defects such as corrosion or peeling may occur due to stimulation inside and outside the battery in an actual use environment.

According to one embodiment of the present invention, the lead tab (10) can have a surface energy of 41 dyne/cm or more. The surface energy according to one embodiment of the present invention is calculated using the Owens-Wendt geometric mean method by substituting the contact angle values measured in accordance with the embodiment of the present invention. The method of measuring the surface energy according to one embodiment of the present invention is described in detail below.

According to one embodiment of the present invention, when the lead tab (10) has a surface energy of 41 dyne/cm or more, no defects occur on the surface of the metal layer (130), so that the bonding strength between the metal layer (130) of the lead tab (10) and the sealing tape (20) is improved, and thus defects such as corrosion or peeling due to stimulation inside and outside the battery may not occur in an actual use environment.

On the other hand, if the lead tab (10) has a surface energy of less than 41 dyne/cm, the metal layer (130) of the lead tab (10) and the sealing tape (20) do not adhere properly, and a problem of poor adhesion occurs. As a result, defects such as corrosion or peeling may occur due to stimulation inside and outside the battery in an actual use environment.

Preferably, the lead tab (10) may have a surface energy of 41 to 60 dyne/cm. More preferably, the lead tab (10) may have a surface energy of 41 to 50 dyne/cm.

According to one embodiment of the present invention, the lead tab (10) may have L of 60 to 70, a of -2 or less, and b of -4 or less based on the Lab colorimetric system. The colorimetric system according to one embodiment of the present invention is a colorimetric system using L, a, and b values measured by a spectrophotometer (KONICA MINOLTA, CM-5 product) as coordinates. Based on the Lab colorimetric system, if the L value of the surface of the lead tab (10) is 100, it appears white, and if it is 0, it appears black. In addition, as the a value increases in the positive (+) direction, it becomes red, and as the a value increases in the negative (-) direction, it becomes green. As the b value increases in the positive (+) direction, it gradually becomes yellow, and as the b value increases in the negative (-) direction, it gradually becomes blue.

According to one embodiment of the present invention, when the lead tab (10) has L of 60 to 70, a of -2 or less, and b of -4 or less based on the Lab colorimetric system, the metal layer (130) disposed on the outermost surface of the lead tab (10) has a uniform surface structure, so that the bonding strength with the sealing tape (20) is improved, and thus defects such as corrosion or peeling due to stimulation inside and outside the battery may not occur in an actual use environment.

On the other hand, if the lead tab (10) is outside the range of L, a, and b of 60 to 70, -2 or less, and -4 or less, respectively, based on the Lab color system, the metal layer (130) of the lead tab (10) and the sealing tape (20) are not properly adhered, and a problem of poor adhesion occurs. As a result, defects such as corrosion or peeling may occur due to stimulation inside and outside the battery in an actual use environment.

According to one embodiment of the present invention, the metal layer (130) may have a thickness of 10 to 500 nm.

When the metal layer (130) has a thickness of less than 10 nm, the metal layer (130) may be deposited unevenly, and as a result, when forming the secondary battery (1), the sealing tape (20) disposed on the metal layer (130) may be deposited unevenly, which may cause a problem in that the electrolyte (164) inside the secondary battery (1) may leak.

In addition, when the metal layer (130) exceeds a thickness of 500 nm, the internal stress within the metal layer (130) increases, causing a problem of cracks. Based on this, the metal layer (130) according to the embodiment of the present invention needs to have a thickness of 10 to 500 nm. Preferably, the metal layer (130) can have a thickness of 10 to 200 nm.

Below, a method for manufacturing a lead tab (10) according to one embodiment of the present invention is specifically described.

First, prepare a metal substrate (110).

The metal substrate (110) may have a thickness of 100 to 1,000 µm, and although the material is not particularly limited. According to one embodiment of the present invention, the metal substrate (110) may be rolled copper foil.

Next, a nickel-plated layer (120) is formed on the metal substrate (110). The nickel-plated layer (120) can be formed to have a thickness of 0.5 to 10.0 *µ*m through an electroplating process using roll-to-roll equipment.

Below, the electroplating process of the present invention for forming a nickel-plated layer (120) is described in more detail.

The electroplating of the present invention is performed by passing the metal substrate (110) through an electrolyte.

According to the present invention, during the electroplating process, the electrolyte is maintained at 40 to 60° C. and pH 3.5 to 4.5. In addition, the plating solution contains 350 to 600 g/L of nickel sulfamate, 10 to 20 g/L of nickel chloride, 30 to 50 g/L of boric acid, and 0.01 to 0.02 g/L of a pitting inhibitor.

According to one embodiment of the present invention, the pitting inhibitor includes NS-AP (MKCAMENTEC Co., Ltd.).

The electroplating process can be performed at a speed of 2 to 3 m/min until the thickness of the nickel-plated layer (120) becomes 0.5 to 10.0 *µ*m.

The current density applied during the electroplating process can be 5 to 12 A/dm2.

The electroplating process may be a vertical process.

Next, a metal layer (130) can be formed on the nickel-plated layer (120) through a sputtering process using a DC sputtering device. The metal layer (130) can have a thickness of 10 to 500 nm

At this time, chromium (Cr) metal is used as the target for sputtering.

Hereinafter, the present invention will be specifically described through examples and comparative examples. However, the following examples are only intended to help understanding the present invention, and the scope of the present invention is not limited to these examples.

### Example 1

After preparing a rolled copper foil as a metal substrate, a nickel-plated layer having a thickness of 2 *µ*m was formed on both sides of the metal substrate using an electroplating process. At this time, the electrolyte for forming the nickel-plated layers had a composition of 600 g/L of nickel sulfamate, 15 g/L of nickel chloride, 40 g/L of boric acid, and 0.02 g/L of a pitting inhibitor. The electrolyte temperature was set to 50°C, the pH was adjusted to 4.0, and the current density was set to 10 A/dm². The electroplating process was carried out at a line speed of 2.5 m/min.

At this time, NS-AP (MK Camentec) was used as a pitting inhibitor.

Next, a metal layer having a thickness of 20 nm was formed on the nickel-plated layer using a sputtering process, thereby completing a 300 µm lead tab. Chromium (Cr) metal was used as a target during the sputtering process.

### Example 2

lead tab was completed using the same method as Example 1, except that the concentration of nickel sulfamate in the electrolyte was 500 g/L when forming the nickel-plated layer.

### Example 3

A lead tab was completed using the same method as Example 1, except that the concentration of nickel chloride in the electrolyte was 20 g/L when forming the nickel-plated layer.

### Example 4

A lead tab was completed using the same method as Example 1, except that the concentration of boric acid in the electrolyte was 35 g/L when forming the nickel-plated layer.

### Example 5

A lead tab was completed using the same method as Example 1, except that the concentration of the pitting inhibitor in the electrolyte was 0.15 g/L when forming the nickel-plated layer.

### Comparative Example 1

After preparing a rolled copper foil as the metal substrate, nickel-plated layers with a thickness of 2 µm were formed on both sides of the metal substrate using an electroplating process. In this process, the electrolyte for forming the nickel-plated layers contained 600 g/L of nickel sulfamate, 15 g/L of nickel chloride, 40 g/L of boric acid, and 0.02 g/L of an pitting inhibitor. The electrolyte temperature was set to 50°C, the pH was adjusted to 4.0, and the current density was maintained at 10 A/dm². The electroplating process was carried out at a line speed of 2.5 m/min.

At this time, NS-AP (MK Camentec) was used as a pitting inhibitor.

Next, a metal substrate having nickel-plated layers formed on both sides was immersed in a 0.06 M chromate solution at room temperature for 20 seconds, dried at room temperature for 10 seconds, rinsed with distilled water for 10 seconds, immersed in a 0.06 M chromate solution at room temperature for 10 seconds, dried at room temperature for 10 seconds, rinsed with distilled water for 10 seconds, and dried for 15 seconds to form a protective layer having a thickness of 20 nm. Except for this step, the lead tab having a thickness of 300 µm was prepared using the same method as in Example 1.

### Comparative Example 2

A lead tab was completed using the same method as Comparative Example 1, except that the concentration of nickel sulfamate in the electrolyte was 500 g/L when forming the nickel-plated layer.

### Comparative Example 3

A lead tab was completed using the same method as Comparative Example 1, except that the concentration of nickel chloride in the electrolyte was 20 g/L when forming the nickel-plated layer.

### Comparative Example 4

A lead tab was completed using the same method as Comparative Example 1, except that the concentration of boric acid in the electrolyte was 35 g/L when forming the nickel-plated layer.

### Comparative Example 5

A lead tab was completed using the same method as Comparative Example 1, except that the concentration of the pitting inhibitor in the electrolyte was 0.15 g/L when forming the nickel-plated layer.

The gloss, water contact angle, and roughness (Ra, Ry, Rz) of the lead tabs depending on whether the metal layer was formed by the sputtering process in the above Examples 1 to 5 and Comparative Examples 1 to 5 are as shown in Table 1 below. In addition, the surface energy and chromaticity values of the lead tabs depending on whether the metal layer was formed by the sputtering process in the above Examples 1 to 5 and Comparative Examples 1 to 5 are as shown in Table 2 below.

**[Table 1]**

| | Whether the metal layer is formed by a sputtering process | gloss (Gs 60°) | water contact angle (°) | Ra (*µ*m) | Ry (*µ*m) | Rz (*µ*m) |
|---|---|---|---|---|---|---|
| Example 1 | O | 81.8 | 74.49 | 0.09 | 0.68 | 0.48 |
| Example 2 | O | 81.2 | 75.51 | 0.08 | 0.63 | 0.47 |
| Example 3 | O | 72.5 | 76.53 | 0.06 | 0.69 | 0.53 |
| Example 4 | O | 76.9 | 73.87 | 0.09 | 0.45 | 0.32 |
| Example 5 | O | 91.2 | 75.43 | 0.10 | 0.70 | 0.50 |
| Comparative Example 1 | X | 133.1 | 81.03 | 0.04 | 0.35 | 0.28 |
| Comparative Example 2 | X | 133.6 | 81.68 | 0.04 | 0.36 | 0.29 |
| Comparative Example 3 | X | 133.4 | 80.77 | 0.03 | 0.32 | 0.29 |
| Comparative Example 4 | X | 112.5 | 83.56 | 0.05 | 0.36 | 0.27 |
| Comparative Example 5 | X | 127.3 | 84.45 | 0.05 | 0.35 | 0.25 |

**[Table 2]**

| | surface energy (dyne/cm) | L | a | b |
|---|---|---|---|---|
| Example 1 | 45.66 | 62.92 | -2.35 | -4.09 |
| Example 2 | 44.52 | 62.44 | -2.42 | -4.01 |
| Example 3 | 44.83 | 61.73 | -2.35 | -4.28 |
| Example 4 | 46.46 | 63.01 | -2.44 | -4.10 |
| Example 5 | 46.05 | 65.55 | -2.40 | -4.30 |
| Comparative Example 1 | 40.48 | 80.22 | 0.75 | 6.31 |
| Comparative Example 2 | 39.38 | 80.25 | 0.74 | 6.2 |
| Comparative Example 3 | 40.44 | 80.07 | 0.75 | 6.27 |
| Comparative Example 4 | 40.79 | 80.18 | 0.75 | 6.26 |
| Comparative Example 5 | 40.88 | 80.20 | 0.77 | 6.25 |

### i) Gloss measurement

For the surfaces of the lead tab (10) samples prepared in Examples 1 to 5 and Comparative Examples 1 to 5, gloss measurements were performed using a Gloss Meter (model VG8000 by Nippon Denshoku) at a light incidence angle of 60°, with the surface to be measured facing downward and aligned with the slit. Specifically, gloss was measured on the surface of the metal layer (130) of the lead tab (10) samples.

At this time, the lead tab samples are cut to a size of 100 mm x 100 mm (width: 100 mm, length: 100 mm) from the lead tabs manufactured in Examples 1 to 5 and Comparative Examples 1 to 5, and formed to a thickness of 300 *µ*m.

### ii) Measurement of water contact angle

For the surfaces of the lead tab (10) samples prepared in Examples 1 to 5 and Comparative Examples 1 to 5, contact angle measurements were conducted using a contact angle meter (Phoenix-MT, manufactured by SEO). The surface to be measured was positioned facing upward and fixed on the stage during measurement. Specifically, the water contact angle was measured on the surface of the metal layer (130) of the lead tab (10) samples.

The specific conditions are as follows.
Temperature: 25°C
Humidity: 50RH%
Drop volume: 0.8 µℓ

### iii) Surface energy measurement

The surface energy was calculated by substituting the numerical value of the water contact angle according to the Owens-Wendt-geometric mean method.

### iv) Measurement of roughness (Ra, Ry, Rz)

For the surfaces of the lead tab (10) samples prepared in Examples 1 to 5 and Comparative Examples 1 to 5, roughness (Ra, Ry, Rz) were measured using a profiler (Surfcorder ET3000, manufactured by KOSKA Lab). The surface to be measured was positioned facing upward and fixed on the stage during measurement. Specifically, the surface roughness (Ra, Ry, Rz) was measured on the surface of the metal layer (130) of the lead tab (10) samples.

The specific conditions are as follows.
Measurement length: 0.8 mm
Measurement speed: 0.1 mm/s

### v) Chromaticity value measurement

For the surfaces of the lead tab (10) samples prepared in Examples 1 to 5 and Comparative Examples 1 to 5, measurements were performed using a spectrophotometer (CM-5, manufactured by KONICA MINOLTA), with the surface to be measured facing downward and aligned with the slit. Specifically, the chromaticity values were measured on the surface of the metal layer (130) of the lead tab (10) samples.

The specific conditions are as follows.
Light source: xenon lamp (D65)
Angle of view: 10 degrees
Wavelength range: 360 to 740 nm
Wavelength interval: 10nm
Reference: air
Referring to Table 1, the following results can be confirmed.

In the case of the lead tabs of Examples 1 to 5 in which a metal layer was formed on a nickel-plated layer by a sputtering process, it can be seen that the desired properties were obtained.

On the other hand, it can be seen that the lead tabs of Comparative Examples 1 to 5, in which a protective layer was formed on a nickel-plated layer through chromate treatment without forming a metal layer by a sputtering process, did not obtain the desired physical properties.

In addition to the effects mentioned above, other features and advantages of the present invention are described below or may be clearly understood by those skilled in the art to which the present invention pertains from such description and explanation.

According to the present invention, a lead tab with improved adhesion can be provided.

It will be apparent to those skilled in the art that the present disclosure described above is not limited by the above-described embodiments and the accompanying drawings and that various substitutions, modifications and variations can be made in the present disclosure without departing from the scope of the disclosures. Consequently, the scope of the present disclosure is defined by the accompanying claims and it is intended that all variations or modifications derived from the meaning, scope and equivalent concept of the claims fall within the scope of the present disclosure.

## Claims

1. A lead tab comprising:
a metal substrate including copper;
a nickel-plated layer disposed on both sides of the metal substrate; and
a metal layer on the nickel-plated layer,
wherein the metal layer comprises 70 to 99.9 wt% of chromium and
wherein the lead tab has a gloss of 60 to 100 (Gs 60°) and a water contact angle of 60 to 80°.

2. The lead tab of claim 1, wherein the lead tab has an arithmetic mean roughness (Ra) of 0.06 to 0.15 *µ*m, a maximum height roughness (Ry) of 0.4 to 0.8 *µ*m, and a 10-point average roughness (Rz) of 0.3 to 0.6 *µ*m.

3. The lead tab of claim 1 or 2, wherein the lead tab has a surface energy of 41 dyne/cm or more.

4. The lead tab according to any one of the preceding claims, wherein the lead tab has L of 60 to 70, a of -2 or less, and b of -4 or less based on a Lab colorimetric system.

5. The lead tab according to any one of the preceding claims, wherein the metal substrate is a rolled copper foil.

6. The lead tab according to any one of the preceding claims, wherein the metal substrate has a thickness of 100 to 1,000 µm.

7. The lead tab according to any one of the preceding claims, wherein the nickel-plated layer has a thickness of 0.5 to 10.0 µm.

8. The lead tab according to any one of the preceding claims, wherein the metal layer has a thickness of 10 to 500 nm.

9. The lead tab according to any one of the preceding claims, wherein the metal layer is formed by a dry vacuum process.

10. The lead tab of claim 9, wherein the dry vacuum process comprises at least one of a sputtering process, an evaporation process, an ion plating process, and a CVD process.

11. A secondary battery comprising the lead tab of any one of claims 1 to 10.

## Patentansprüche

1. Kontaktfahne, die Folgendes umfasst:
ein Metallsubstrat, das Kupfer enthält;
eine Nickelplattierungsschicht, die auf beiden Seiten des Metallsubstrats angeordnet ist; und
eine Metallschicht auf der Nickelplattierungsschicht,
wobei die Metallschicht 70 bis 99,9 Gew.-% Chrom umfasst und
wobei die Kontaktfahne einen Glanz im Bereich von 60 bis 100 (Gs 60°) und einen Wasserkontaktwinkel im Bereich von 60° bis 80° aufweist.

2. Kontaktfahne nach Anspruch 1, wobei die Kontaktfahne ein arithmetisches Mittel (Ra) der Rauigkeit im Bereich von 0,06 bis 0,15 µm, eine maximale Höhe (Ry) der Rauigkeit im Bereich von 0,4 bis 0,8 µm und einen 10-Punkte-Mittelwert (Rz) der Rauigkeit im Bereich von 0,3 bis 0,6 µm aufweist.

3. Kontaktfahne nach Anspruch 1 oder 2, wobei die Kontaktfahne eine Oberflächenenergie von 41 dyne/cm [1 mN/m] oder höher aufweist.

4. Kontaktfahne nach einem der vorhergehenden Ansprüche, wobei die Kontaktfahne L im Bereich von 60 bis 70, a von -2 oder kleiner und b von -4 oder kleiner auf der Grundlage eines farbmetrischen Systems Lab aufweist.

5. Kontaktfahne nach einem der vorhergehenden Ansprüche, wobei das Metallsubstrat eine aufgerollte Kupferfolie ist.

6. Kontaktfahne nach einem der vorhergehenden Ansprüche, wobei das Metallsubstrat eine Dicke im Bereich von 100 bis 1000 µm aufweist.

7. Kontaktfahne nach einem der vorhergehenden Ansprüche, wobei die Nickelplattierungsschicht eine Dicke im Bereich von 0,5 bis 10,0 µm aufweist.

8. Kontaktfahne nach einem der vorhergehenden Ansprüche, wobei die Metallschicht eine Dicke im Bereich von 10 bis 500 nm aufweist.

9. Kontaktfahne nach einem der vorhergehenden Ansprüche, wobei die Metallschicht durch einen Trockenvakuumprozess gebildet wird.

10. Kontaktfahne nach Anspruch 9, wobei der Trockenvakuumprozess einen Zerstäubungsprozess und/oder einen Verdampfungsprozess und/oder einen Ionenplattierungsprozess und/oder einen CVD-Prozess umfasst.

11. Sekundärbatterie, die die Kontaktfahne nach einem der Ansprüche 1 bis 10 aufweist.

## Revendications

1. Languette de connexion comportant :
un substrat métallique incluant du cuivre ;
une couche nickelée disposée des deux côtés du substrat métallique ; et
une couche métallique sur la couche nickelée,
dans laquelle la couche métallique comporte 70 à 99,9 % en poids de chrome et
dans laquelle la languette de connexion présente un brillant de 60 à 100 (Gs 60°) et un angle de contact avec l'eau de 60 à 80°.

2. Languette de connexion selon la revendication 1, dans laquelle la languette de connexion a une rugosité moyenne arithmétique (Ra) de 0,06 à 0,15 *µ*m, une rugosité maximale en hauteur (Ry) de 0,4 à 0,8 *µ*m, et une rugosité moyenne en 10 points (Rz) de 0,3 à 0,6 *µ*m.

3. Languette de connexion selon la revendication 1 ou 2, dans laquelle la languette de connexion a une énergie de surface de 41 dynes/cm ou plus.

4. Languette de connexion selon l'une quelconque des revendications précédentes, dans laquelle la languette de connexion a une valeur L de 60 à 70, une valeur a égale à -2 ou moins et une valeur b égale à -4 ou moins, sur la base d'un système colorimétrique Lab.

5. Languette de connexion selon l'une quelconque des revendications précédentes, dans laquelle le substrat métallique est une feuille de cuivre laminée.

6. Languette de connexion selon l'une quelconque des revendications précédentes, dans laquelle le substrat métallique a une épaisseur de 100 à 1 000 µm.

7. Languette de connexion selon l'une quelconque des revendications précédentes, dans laquelle la couche nickelée a une épaisseur de 0,5 à 10,0 µm.

8. Languette de connexion selon l'une quelconque des revendications précédentes, dans laquelle la couche métallique a une épaisseur de 10 à 500 nm.

9. Languette de connexion selon l'une quelconque des revendications précédentes, dans laquelle la couche métallique est formée par un processus sous vide à sec.

10. Languette de connexion selon la revendication 9, dans laquelle le processus sous vide à sec comporte au moins un processus parmi un processus de pulvérisation sous vide, un processus d'évaporation, un processus de placage ionique et un processus CVD.

11. Batterie secondaire comportant la languette de connexion selon l'une quelconque des revendications 1 à 10.
